# EUROPEAN PATENT APPLICATION

(11) **EP 4 852 316 A1**
(43) Date of publication of application: **09.12.2026**
(21) Application number: 26183067.3
(22) Date of filing: 04.06.2026
(51) Int. Cl.: H03F 3/08, H03F 1/08, H03F 3/45

(54) **HIGH SPEED AND HIGH GAIN TRANSIMPEDANCE AMPLIFIER SOURCE IMPEDANCE ALTERNATING CURRENT CANCELLATION**

(30) Priority: 06.06.2025 US 202519230611
(71) Applicant: Analog Devices, Inc., Wilmington, MA 01887 (US)
(72) Inventor: HEMATY, Arman, Wilmington, 01887 (US)
(74) Representative: Yang, Shu

(57) **Abstract**

A circuit includes a first amplifier configured to operate as a transimpedance amplifier (TIA) by receiving an input current on an inverting input terminal and generating an output voltage based on the input current. The circuit also includes a second amplifier, wherein a non-inverting input terminal of the second amplifier is connected to an inverting input terminal of the first amplifier. The circuit further includes a capacitance compensation network located in between the first amplifier and the second amplifier, wherein the capacitance compensation network is configured to compensate for an input capacitance at the TIA so as to increase an operating bandwidth of the TIA. The capacitance compensation network includes at least a first capacitor connected in between an output terminal of the amplifier and the inverting input terminal of the TIA, wherein a capacitance of the first capacitor matches a total input capacitance associated with the TIA.

## Description

### BACKGROUND

### Related Applications

This application claims the benefit of priority to U.S. Provisional Patent Application No. 19/230,611 filed June 6, 2025 and titled "HIGH SPEED AND HIGH GAIN TRANSIMPEDANCE AMPLIFIER SOURCE IMPEDANCE ALTERNATING CURRENT CANCELLATION", the disclosures of which are incorporated herein by reference.

### Technical Field

Embodiments described herein relate to circuitry, and more particularly, but not by way of limitation, to techniques for implementing high speed and high gain transimpedance amplifiers with source impedance alternating current cancellation.

### Description of the Related Art

Transimpedance amplifiers (TIA) are used in many applications. High speed current and light sensing are common use cases in industrial, medical, and automotive markets. In addition to high bandwidth, most applications require TIA to have excellent linearity, lower noise, and very high transimpedance gain.

### SUMMARY

Various embodiments of systems, apparatuses, and methods for implementing high speed and high gain transimpedance amplifier source impedance alternating current cancellation techniques are contemplated.

In one embodiment, a circuit includes a first amplifier configured to operate as a transimpedance amplifier by: receiving an input current on an inverting input terminal; and generating an output voltage based on the input current. In this embodiment, the circuit also includes a second amplifier, wherein a non-inverting input terminal of the second amplifier is connected to an inverting input terminal of the first amplifier. In this embodiment, the circuit further includes a capacitance compensation network located in between the first amplifier and the second amplifier, wherein the capacitance compensation network is configured to compensate for an input capacitance at the transimpedance amplifier so as to increase an operating bandwidth of the transimpedance amplifier.

In one embodiment, the capacitance compensation network may include a first capacitor connected in between an output terminal of the second amplifier and the inverting input terminal of the first amplifier, wherein a capacitance of the first capacitor is within a threshold percentage of a total input capacitance associated with the inverting input terminal of the first amplifier. The circuit may also include a photodetector configured to generate the input current based on a received illumination. In one embodiment, the capacitance compensation network further includes a pair of resistors connected in series between the output terminal of the amplifier and ground, wherein a midpoint of the pair of resistors is connected to an inverting input terminal of the amplifier.

These and other embodiments will become apparent upon consideration of the following description and accompanying drawings.

### BRIEF DESCRIPTION OF THE DRAWINGS

FIG. 1 is a diagram of a TIA circuit, according to an embodiment of the present disclosure.
FIG. 2 illustrates a diagram of a TIA circuit, according to an embodiment of the present disclosure.
FIG. 3 illustrates a Bode plot of an uncompensated transimpedance amplifier, according to an embodiment of the present disclosure.
FIG. 4 illustrates a Bode plot of a compensated transimpedance amplifier, according to an embodiment of the present disclosure.
FIG. 5 illustrates a diagram of a circuit that cancels unwanted AC current generated by all parasitic capacitors connected to a sensitive TIA input, according to an embodiment of the present disclosure.
FIG. 6 illustrates plots of the simulated current in the source capacitor, bootstrapping capacitor, and at the input of the uncompensated TIA, according to an embodiment of the present disclosure.
FIG. 7 illustrates plots of the simulated current in the source capacitor, bootstrapping capacitor, and at the input of the compensated TIA, according to an embodiment of the present disclosure.
FIG. 8 illustrates plots of the actual current in the source capacitor, bootstrapping capacitor, and at the input of the uncompensated TIA, according to an embodiment of the present disclosure.
FIG. 9 illustrates plots of the actual current in the source capacitor, bootstrapping capacitor, and at the input of the compensated TIA, according to an embodiment of the present disclosure.
FIG. 10 illustrates the bandwidth improvement achieved by compensating for the source capacitance, according to an embodiment of the present disclosure.
FIG. 11 is a generalized flow diagram illustrating one embodiment of a method for implementing a high speed and high gain transimpedance amplifier, according to an embodiment of the present disclosure.

While the methods and mechanisms described herein are susceptible to various modifications and alternative forms, specific embodiments are shown by way of example in the drawings and are herein described in detail. It should be understood, however, that drawings and detailed description thereto are not intended to limit the methods and mechanisms to the particular form disclosed, but on the contrary, are intended to cover all modifications, equivalents and alternatives apparent to those skilled in the art once the disclosure is fully appreciated.

### DETAILED DESCRIPTION

In the following description, numerous specific details are set forth to provide a thorough understanding of the methods and mechanisms presented herein. However, one having ordinary skill in the art should recognize that the various embodiments may be practiced without these specific details. In some instances, well-known structures, components, signals, computer program instructions, and techniques have not been shown in detail to avoid obscuring the non-limiting examples described herein. It will be appreciated that for simplicity and clarity of illustration, elements shown in the figures have not necessarily been drawn to scale. For example, the dimensions of some of the elements may be exaggerated relative to other elements.

This specification includes references to "one embodiment". The appearance of the phrase "in one embodiment" in different contexts does not necessarily refer to the same embodiment. Particular features, structures, or characteristics may be combined in any suitable manner consistent with this disclosure. Furthermore, as used throughout this application, the word "may" is used in a permissive sense (i.e., meaning having the potential to), rather than the mandatory sense (i.e., meaning must). Similarly, the words "include", "including", and "includes" mean including, but not limited to.

Terminology. The following paragraphs provide definitions and/or context for terms found in this disclosure (including the appended claims):

"Comprising." This term is open-ended. As used in the appended claims, this term does not foreclose additional structure or steps. Consider a claim that recites: "A system comprising an amplifier...." Such a claim does not foreclose the system from including additional components (e.g., a capacitor, a resistor, a central processing unit).

"Configured To." Various units, circuits, or other components may be described or claimed as "configured to" perform a task or tasks. In such contexts, "configured to" is used to connote structure by indicating that the units/circuits/components include structure (e.g., circuitry) that performs the task or tasks during operation. As such, the unit/circuit/component can be said to be configured to perform the task even when the specified unit/circuit/component is not currently operational (e.g., is not on). The units/circuits/components used with the "configured to" language include hardware-for example, circuits, memory storing program instructions executable to implement the operation, etc. Reciting that a unit/circuit/component is "configured to" perform one or more tasks is expressly intended not to invoke 35 U.S.C. § 112, paragraph (f), for that unit/circuit/component. Additionally, "configured to" can include generic structure (e.g., generic circuitry) that is manipulated by software and/or firmware (e.g., an FPGA or a general-purpose processor executing software) to operate in a manner that is capable of performing the task(s) at issue. "Configured to" may also include adapting a manufacturing process (e.g., a semiconductor fabrication facility) to fabricate devices (e.g., integrated circuits) that are adapted to implement or perform one or more tasks.

"Based On." As used herein, this term is used to describe one or more factors that affect a determination. This term does not foreclose additional factors that may affect a determination. That is, a determination may be solely based on those factors or based, at least in part, on those factors. Consider the phrase "determine A based on B." While B may be a factor that affects the determination of A, such a phrase does not foreclose the determination of A from also being based on C. In other instances, A may be determined based solely on B.

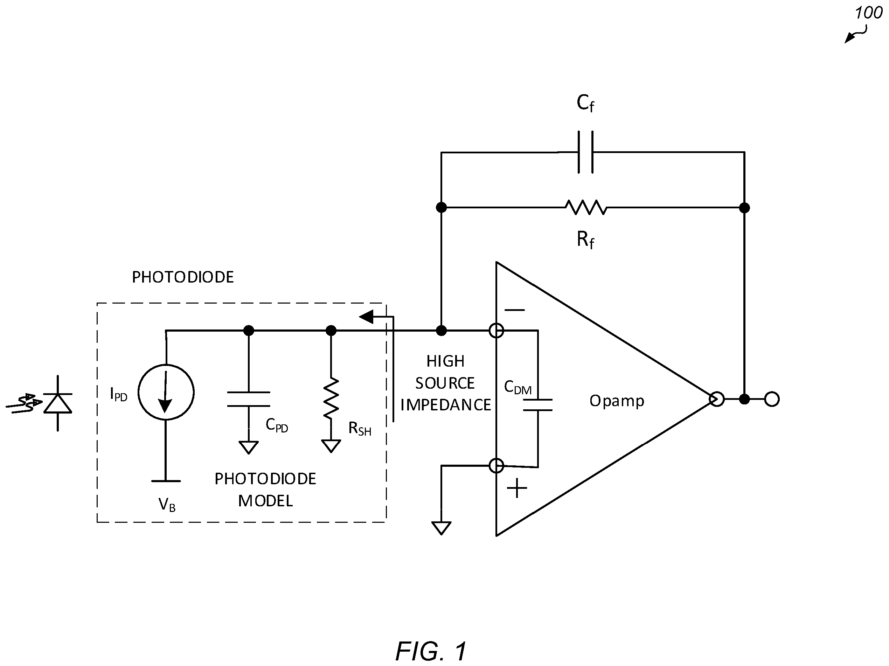

Referring now to the example embodiment of FIG. 1, a diagram of a transimpedance amplifier (TIA) circuit 100 is shown. In the example embodiment of FIG. 1, TIA circuit 100 includes a sensing photodiode, where C_{PD} is the photo diode junction capacitor, R_{SH} is the photo diode dark current parasitic (for this discussion it may be assumed that R_{SH} is infinity), C_{DM} is the input capacitance of the TIA amplifier, C_{f} is the compensation capacitor, and R_{f} is the transimpedance resistor. In other embodiments, TIA circuit 100 may include other components, omit one of the illustrated components, and/or arranged in other suitable configurations. Accordingly, it should be understood that other types of TIA circuits may be implemented with other structures and arrangements of circuit components.

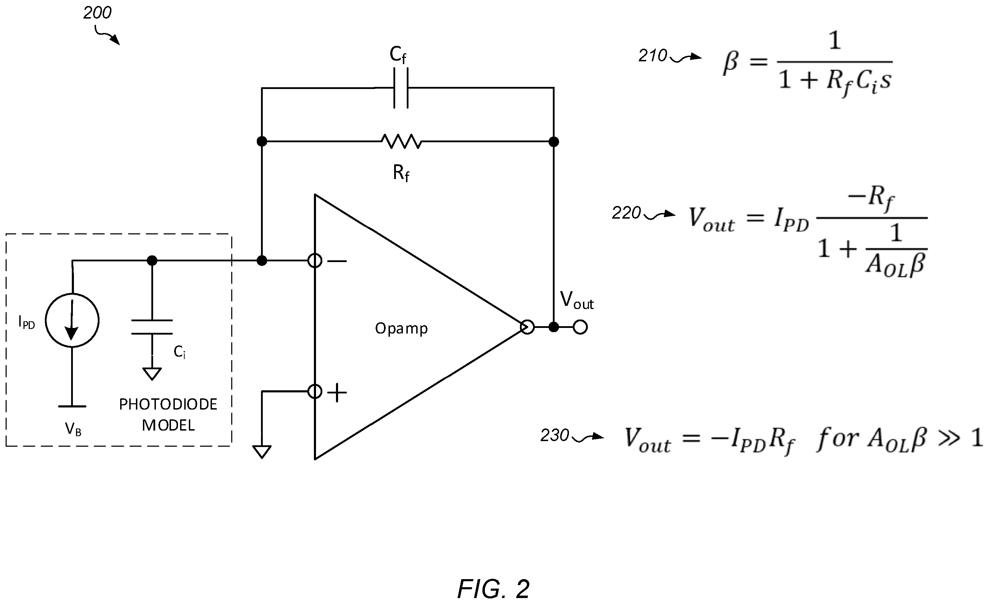

Turning now to the example embodiment of FIG. 2, a diagram of a TIA circuit 200 is shown. In the example embodiment of FIG. 2, Cᵢ is sum of photo diode junction capacitor and input capacitance of the TIA. The low-pass response of this filter can be characterized as the feedback factor β according to equation 210. Therefore, the TIA response is characterized by equation 220, where V_{OL} is the open-loop gain of the op-amp. At low frequencies the feedback factor β has little effect on the amplifier response. The amplifier response will be close to the ideal as shown in equation 230.

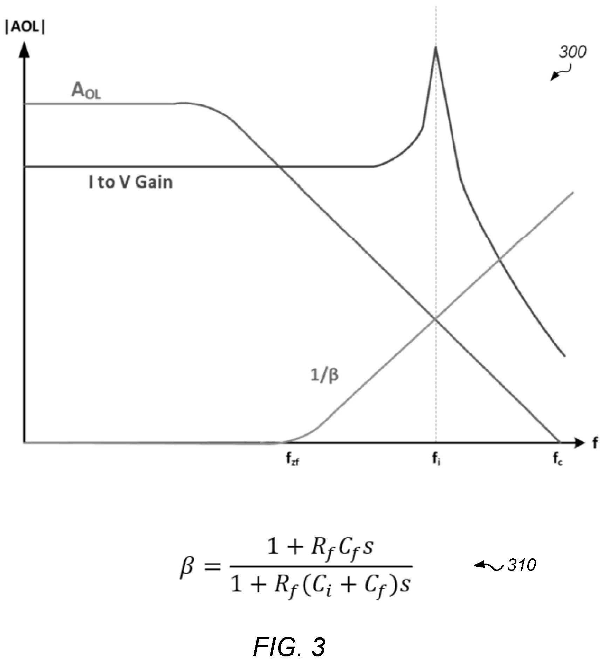

Referring now to the example embodiment of FIG. 3, a Bode plot 300 of an uncompensated transimpedance amplifier is shown. A_{OL} and 1/β curves slopes have a magnitude of 20 dB/decade, corresponding to a phase shift of 90°. When the amplifier's 180° of phase inversion is added to this, the result is a full 360° at the fᵢ intercept, indicated by the dashed vertical line. At that intercept, 1/β = *A*_{OL} for a loop gain of *A*_{OL}β = 1. Oscillation will occur at the frequency fᵢ because of the 360° phase shift, or positive feedback, and the unity gain. To mitigate these effects, a small-value compensating capacitor (*C*_{f} in FIG. 2) may be added in parallel with the feedback resistor R_{f}. When this feedback capacitor is considered, the compensated feedback factor β is characterized by equation 310.

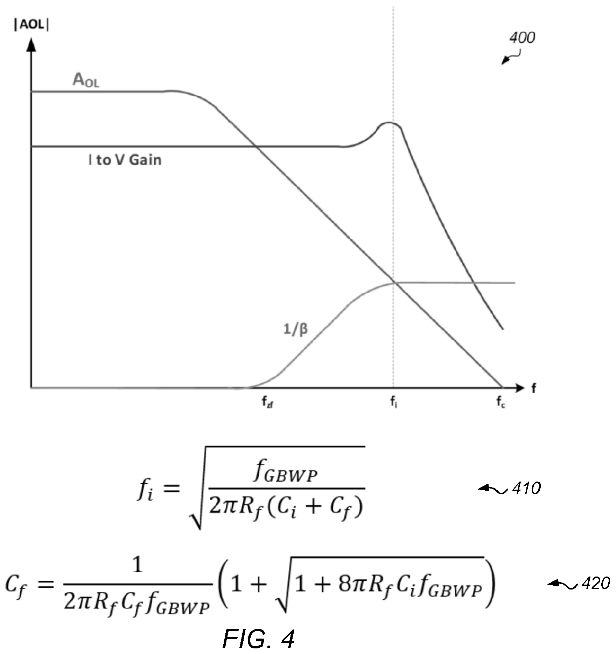

Turning now to the example embodiment of FIG. 4, a Bode plot 400 of a compensated transimpedance amplifier is shown. The intercept frequency fᵢ and compensation capacitor C_{f} formulas may be calculated by equations 410 and 420, respectively, where f_{GBWF} is the gain bandwidth frequency of the amplifier used as the TIA. While the input capacitance Cᵢ may not be able to be eliminated, if a way to make its effect smaller can be implemented, the TIA may be compensated with a smaller C_{f}. With both smaller Cᵢ and C_{f}, the intercept frequency will be higher, and the TIA may operate at a higher bandwidth.

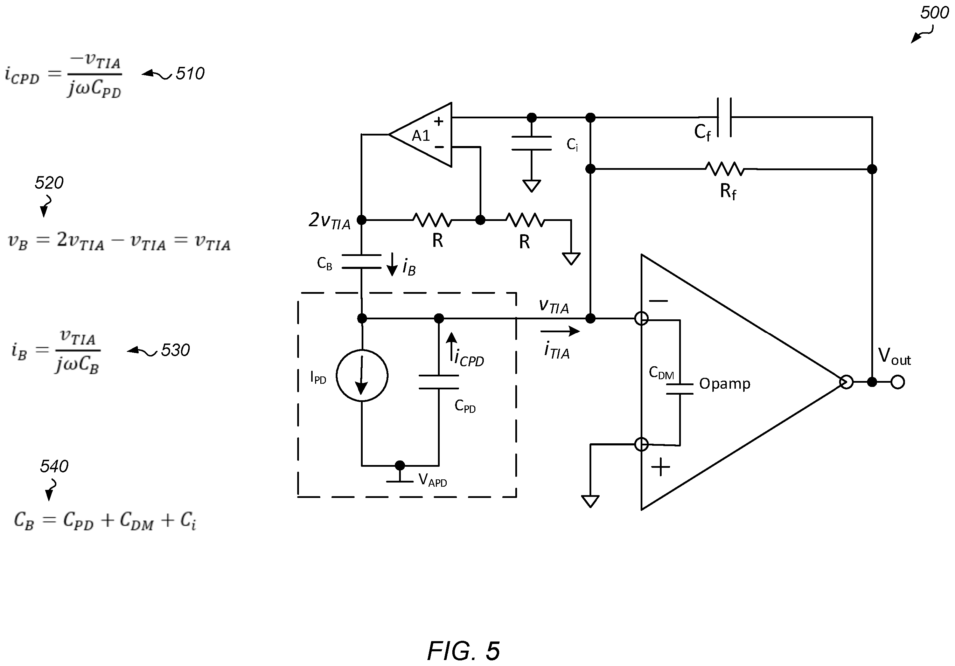

Referring now to the example embodiment of FIG. 5, a circuit 500 that cancels unwanted AC current generated by all parasitic capacitors connected to a sensitive TIA input is shown. The parasitic capacitors connected to the sensitive TIA input include TIA input capacitance, photo diode source capacitance, and any other active and passive circuits.

If it is assumed that there are no other parasitic capacitors other than photo diode source capacitor (C_{PD}) that is connected to the inverting input of TIA, then when a fast pulse of light is converted to current by the photo diode, C_{PD} will conduct AC current according to equation 510 shown on the left-side of FIG. 5. If it is assumed that the bootstrapping amplifier is ideal and has infinite bandwidth with non-inverting gain of two, then the bootstrapping amplifier output will have AC voltage of 2**vₜᵢₐ.* Therefore, voltage *v_{B}* across the bootstrapping capacitor C_{B} will be characterized as shown in equation 520. And the current *i*_{B} through C_{B} will be characterized as shown in equation 530. To cancel this AC error current, C_{B} may be selected to be equal to the photo diode source capacitance. As shown in FIG. 5, there are additional capacitors connected to the non-inverting input of TIA, input capacitance of bootstrapping amplifier Cᵢ, and input capacitance of TIA C_{DM}.

The negative effect of these capacitors may be removed by selecting C_{B} that is equal to the sum of the capacitances shown in equation 540. At least one advantage of this technique is that the undesired effect of any additional parasitic capacitance connected to the TIA may be removed. If A1 is selected to be the same amplifier as TIA, there will be a slight delay through the A1 signal path that causes a slight peaking of the signal after each input pulse transaction.

As shown in circuit 500, the amplifier A1 output is twice the voltage that is across the photodiode capacitor C_{PD}. The combination of C_{B} and C_{PD} acts as a capacitive voltage divider that divides the amplifier A1 output (2**vₜᵢₐ*) down to the same voltage as output of the photo diode (*vₜᵢₐ*.). This means that the compensation capacitor C_{B} is being charged with a higher voltage (i.e., twice the voltage) which may be a more effective technique for charging the compensation capacitor C_{B}.

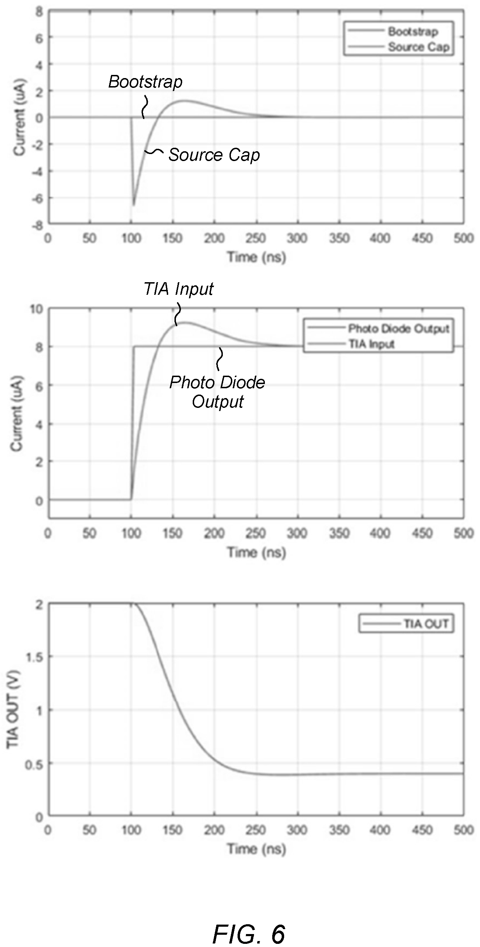

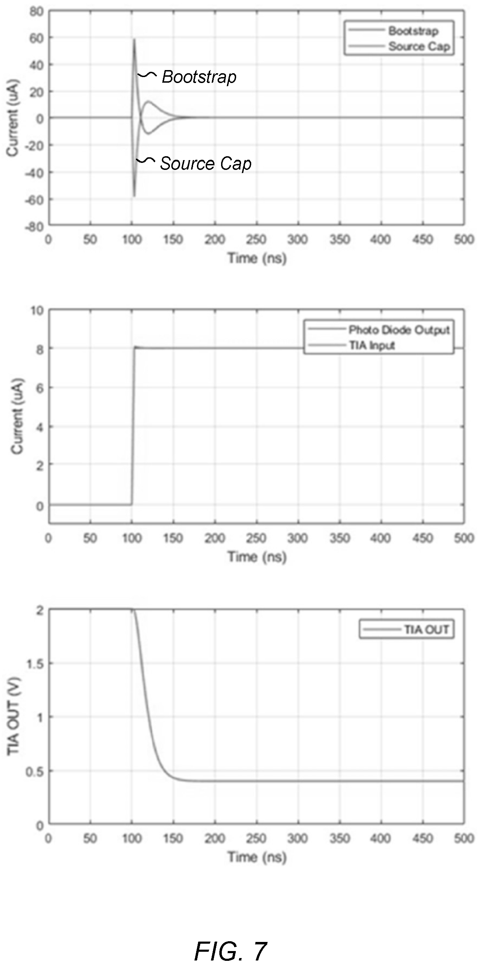

Circuit 500 of FIG. 5 may be simulated for a gain of 200k with LTC6268 (from Analog Devices, Inc.) as TIA and amplifier for the capacitance compensation network. FIG. 6 and FIG. 7 show the current in the source capacitor, bootstrapping capacitor, and at the input of TIA for uncompensated TIA and compensated TIA, respectively, for this simulation. These figures also show bandwidth improvement achieved by compensating the source capacitance.

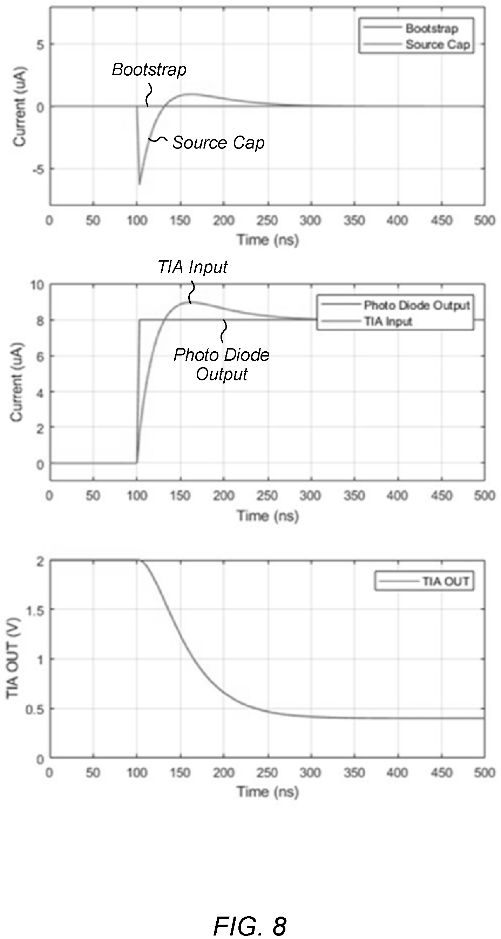

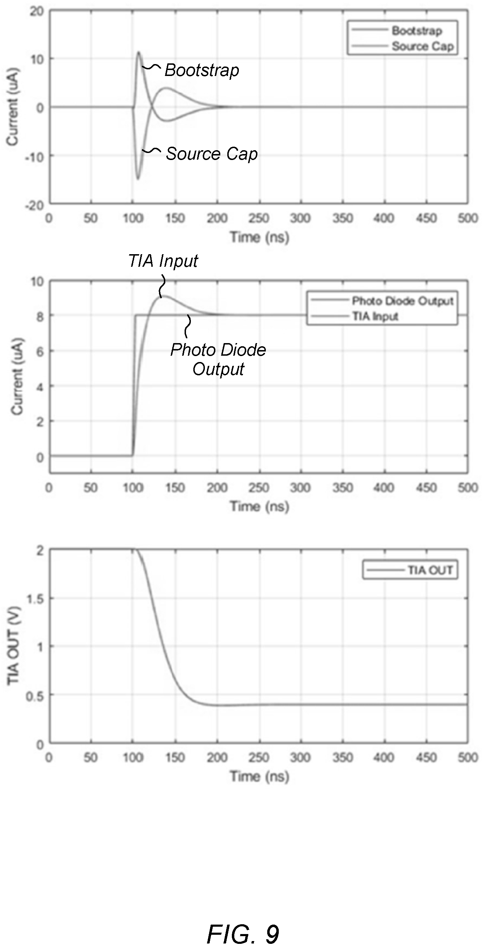

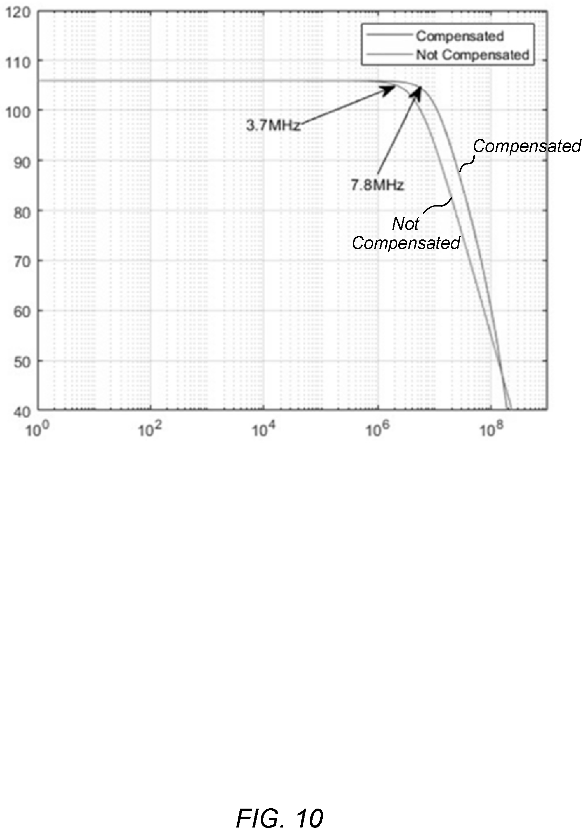

An actual implementation of circuit 500 of FIG. 5 may be evaluated for a gain of 200k with LTC6268 both as TIA and amplifier for the capacitance compensation network. FIG. 8 and FIG 9 show the current in the source capacitor, bootstrapping capacitor, and at the input of TIA for uncompensated TIA and compensated TIA, respectively, for the actual circuit 500. FIG. 10 shows the bandwidth improvement achieved by compensating for the source capacitance.

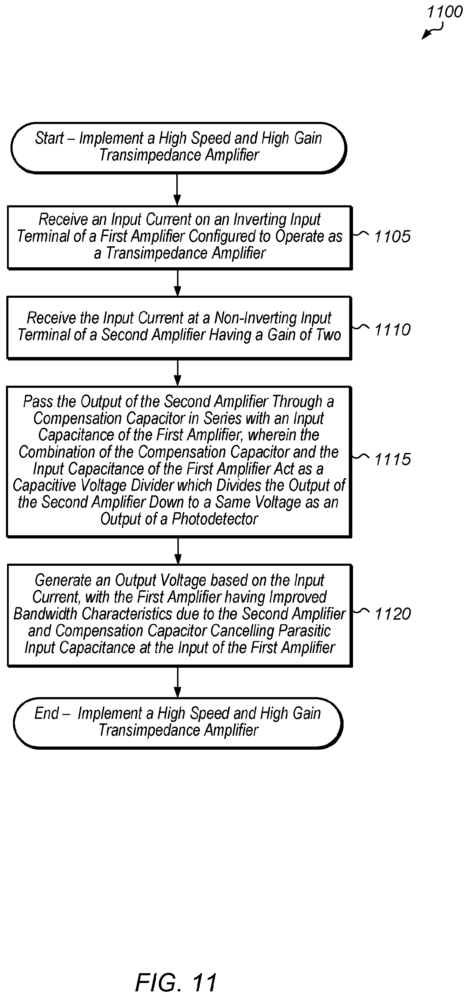

Referring now to the example embodiment of FIG. 11, a method for implementing a high speed and high gain transimpedance amplifier is shown. The components embodied in any of the apparatuses or systems previously described above may generally operate in accordance with method 1100. In addition, the steps in this embodiment are shown in sequential order. However, some steps may occur in a different order than shown, some steps may be performed concurrently, some steps may be combined with other steps, other steps may be added, and some steps may be absent in another embodiment.

An input current is received on an inverting input terminal of a first amplifier configured to operate as a transimpedance amplifier (block 1105). The input current is also received at a non-inverting input terminal of a second amplifier having a gain of two (block 1110). In other embodiments, the second amplifier may be configured to have other amounts of gain besides two. The output of the second amplifier is passed through a compensation capacitor in series with an input capacitance of the first amplifier, wherein the combination of the compensation capacitor and the input capacitance of the first amplifier act as a capacitive voltage divider that divides the output of the second amplifier down to a same voltage as an output of a photodetector (e.g., photo diode) (block 1115). The first amplifier generates an output voltage based on the input current, with the first amplifier having improved bandwidth characteristics due to the compensation capacitor cancelling parasitic input capacitance at the input of the first amplifier (block 1120). After block 1120, method 1100 may end.

Examples, as described herein, may include, or may operate by, logic, components, devices, packages, or mechanisms. Circuitry is a collection (e.g., set) of circuits implemented in tangible entities that include hardware (e.g., simple circuits, gates, logic). Circuitry membership may be flexible over time and underlying hardware variability. Circuitries include members that may, alone or in combination, perform specific tasks. In an example, hardware of the circuitry may be immutably designed to carry out a specific operation (e.g., hardwired). In an example, the hardware of the circuitry may include variably connected physical components (e.g., execution units, transistors, simple circuits) including a computer-readable medium physically modified (e.g., magnetically, electrically, by moveable placement of invariant-massed particles) to encode instructions of the specific operation. In connecting the physical components, the underlying electrical properties of a hardware constituent are changed, for example, from an insulator to a conductor or vice versa. The instructions enable participating hardware (e.g., the execution units or a loading mechanism) to create members of the circuitry in hardware via the variable connections to carry out portions of the specific tasks when in operation. Accordingly, the computer-readable medium is communicatively coupled to the other components of the circuitry when the device is operating. In an example, any of the physical components may be used in more than one member of more than one circuit. For example, under operation, execution units may be used in a first circuit of first circuitry at one point in time and reused by a second circuit in the first circuitry, or by a third circuit in second circuitry, at a different time.

Although ordinal numbers such as first, second and the like can, in some situations, relate to an order; as used in a document ordinal numbers do not necessarily imply an order. For example, ordinal numbers can be merely used to distinguish one item from another. For example, to distinguish a first event from a second event, but need not imply any chronological ordering or a fixed reference system (such that a first event in one paragraph of the description can be different from a first event in another paragraph of the description.

The present disclosure includes references to an "embodiment", to one "embodiment", or to groups of "embodiments" (e.g., "some embodiments" or "various embodiments"). Embodiments are different implementations or instances of the disclosed concepts. References to "an embodiment," "one embodiment," "a particular embodiment," and the like do not necessarily refer to the same embodiment. A large number of possible embodiments are contemplated, including those specifically disclosed, as well as modifications or alternatives that fall within the spirit or scope of the disclosure.

In the descriptions above and in the claims, phrases such as "at least one of" or "one or more of" may occur followed by a conjunctive list of elements or features. The term "and/or" may also occur in a list of two or more elements or features. Unless otherwise implicitly or explicitly contradicted by the context in which it used, such a phrase is intended to mean any of the listed elements or features individually or any of the recited elements or features in combination with any of the other recited elements or features. For example, the phrases "at least one of A and B;" "one or more of A and B;" and "A and/or B" are each intended to mean "A alone, B alone, or A and B together." A similar interpretation is also intended for lists including three or more items. For example, the phrases "at least one of A, B, and C;" "one or more of A, B, and C;" and "A, B, and/or C" are each intended to mean "A alone, B alone, C alone, A and B together, A and C together, B and C together, or A and B and C together." Use of the term "based on," above and in the claims is intended to mean, "based at least in part on," such that an unrecited feature or element is also permissible.

This disclosure may discuss potential advantages that may arise from the disclosed embodiments. Not all implementations of these embodiments will necessarily manifest any or all of the potential advantages. Whether an advantage is realized for a particular implementation depends on many factors, some of which are outside the scope of this disclosure. In fact, there are a number of reasons why an implementation that falls within the scope of the claims might not exhibit some or all of any disclosed advantages. For example, a particular implementation might include other circuitry outside the scope of the disclosure that, in conjunction with one of the disclosed embodiments, negates or diminishes one or more the disclosed advantages. Furthermore, suboptimal design execution of a particular implementation (e.g., implementation techniques or tools) could also negate or diminish disclosed advantages. Even assuming a skilled implementation, realization of advantages may still depend upon other factors such as the environmental circumstances in which the implementation is deployed. For example, inputs supplied to a particular implementation may prevent one or more problems addressed in this disclosure from arising on a particular occasion, with the result that the benefit of its solution may not be realized. Given the existence of possible factors external to this disclosure, it is expressly intended that any potential advantages described herein are not to be construed as claim limitations that must be met to demonstrate infringement. Rather, identification of such potential advantages is intended to illustrate the type(s) of improvement available to designers having the benefit of this disclosure. That such advantages are described permissively (e.g., stating that a particular advantage "may arise") is not intended to convey doubt about whether such advantages can in fact be achieved, but rather to recognize that realization of such advantages often depends on additional factors.

Unless stated otherwise, embodiments are non-limiting. That is, the disclosed embodiments are not intended to limit the scope of claims that are drafted based on this disclosure, even where only a single example is described with respect to a particular feature. The disclosed embodiments are intended to be illustrative rather than restrictive, absent any statements in the disclosure to the contrary. The application is thus intended to permit claims covering disclosed embodiments, as well as such alternatives, modifications, and equivalents that would be apparent to a person skilled in the art having the benefit of this disclosure.

For example, features in this application may be combined in any suitable manner. Accordingly, new claims may be formulated during prosecution of this application (or an application claiming priority thereto) to any such combination of features. In particular, with reference to the appended claims, features from dependent claims may be combined with those of other dependent claims where appropriate, including claims that depend from other independent claims. Similarly, features from respective independent claims may be combined where appropriate.

Accordingly, while the appended dependent claims may be drafted such that each depends on a single other claim, additional dependencies are also contemplated. Any combinations of features in the dependent that are consistent with this disclosure are contemplated and may be claimed in this or another application. In short, combinations are not limited to those specifically enumerated in the appended claims.

Where appropriate, it is also contemplated that claims drafted in one format or statutory type (e.g., apparatus) are intended to support corresponding claims of another format or statutory type (e.g., method).

References to a singular form of an item (i.e., a noun or noun phrase preceded by "a," "an," or "the") are, unless context clearly dictates otherwise, intended to mean "one or more." Reference to "an item" in a claim thus does not, without accompanying context, preclude additional instances of the item. A "plurality" of items refers to a set of two or more of the items.

The word "may" is used herein in a permissive sense (i.e., having the potential to, being able to) and not in a mandatory sense (i.e., must).

The terms "comprising" and "including," and forms thereof, are open-ended and mean "including, but not limited to."

When the term "or" is used in this disclosure with respect to a list of options, it will generally be understood to be used in the inclusive sense unless the context provides otherwise. Thus, a recitation of "x or y" is equivalent to "x or y, or both," and thus covers 1) x but not y, 2) y but not x, and 3) both x and y. On the other hand, a phrase such as "either x or y, but not both" makes clear that "or" is being used in the exclusive sense.

A recitation of "w, x, y, or z, or any combination thereof" or "at least one of ... w, x, y, and z" is intended to cover all possibilities involving a single element up to the total number of elements in the set. For example, given the set [w, x, y, z], these phrasings cover any single element of the set (e.g., w but not x, y, or z), any two elements (e.g., w and x, but not y or z), any three elements (e.g., w, x, and y, but not z), and all four elements. The phrase "at least one of ... w, x, y, and z" thus refers to at least one element of the set [w, x, y, z], thereby covering all possible combinations in this list of elements. This phrase is not to be interpreted to require that there is at least one instance of w, at least one instance of x, at least one instance of y, and at least one instance of z.

Various "labels" may precede nouns or noun phrases in this disclosure. Unless context provides otherwise, different labels used for a feature (e.g., "first circuit," "second circuit," "particular circuit," "given circuit," etc.) refer to different instances of the feature. Additionally, the labels "first," "second," and "third" when applied to a feature do not imply any type of ordering (e.g., spatial, temporal, logical, etc.), unless stated otherwise.

The phrase "based on" or is used to describe one or more factors that affect a determination. This term does not foreclose the possibility that additional factors may affect the determination. That is, a determination may be solely based on specified factors or based on the specified factors as well as other, unspecified factors. Consider the phrase "determine A based on B." This phrase specifies that B is a factor that is used to determine A or that affects the determination of A. This phrase does not foreclose that the determination of A may also be based on some other factor, such as C. This phrase is also intended to cover an embodiment in which A is determined based solely on B. As used herein, the phrase "based on" is synonymous with the phrase "based at least in part on."

The phrases "in response to" and "responsive to" describe one or more factors that trigger an effect. This phrase does not foreclose the possibility that additional factors may affect or otherwise trigger the effect, either jointly with the specified factors or independent from the specified factors. That is, an effect may be solely in response to those factors, or may be in response to the specified factors as well as other, unspecified factors. Consider the phrase "perform A in response to B." This phrase specifies that B is a factor that triggers the performance of A, or that triggers a particular result for A. This phrase does not foreclose that performing A may also be in response to some other factor, such as C. This phrase also does not foreclose that performing A may be jointly in response to B and C. This phrase is also intended to cover an embodiment in which A is performed solely in response to B. As used herein, the phrase "responsive to" is synonymous with the phrase "responsive at least in part to." Similarly, the phrase "in response to" is synonymous with the phrase "at least in part in response to."

Different "circuits" may be described in this disclosure. These circuits or "circuitry" constitute hardware that includes various types of circuit elements, such as combinatorial logic, clocked storage devices (e.g., flip-flops, registers, latches, etc.), finite state machines, memory (e.g., random-access memory, embedded dynamic random-access memory), programmable logic arrays, and so on. Circuitry may be custom designed, or taken from standard libraries. In various implementations, circuitry can, as appropriate, include digital components, analog components, or a combination of both. Certain types of circuits may be commonly referred to as "units" (e.g., a decode unit, an arithmetic logic unit (ALU), functional unit, memory management unit (MMU), etc.). Such units also refer to circuits or circuitry.

The disclosed circuits/units/components and other elements illustrated in the drawings and described herein thus include hardware elements such as those described in the preceding paragraph. In many instances, the internal arrangement of hardware elements within a particular circuit may be specified by describing the function of that circuit. For example, a particular "clamping unit" may be described as performing the function of "clamp an output of an amplifier," which means that the clamping unit is "configured to" perform this function. This specification of function is sufficient, to those skilled in the computer arts, to connote a set of possible structures for the circuit.

The fact that many different low-level combinations of circuit elements may be used to implement the same specification of a circuit results in a large number of equivalent structures for that circuit. As noted, these low-level circuit implementations may vary according to changes in the fabrication technology, the foundry selected to manufacture the integrated circuit, the library of cells provided for a particular project, etc. In many cases, the choices made by different design tools or methodologies to produce these different implementations may be arbitrary.

Moreover, it is common for a single implementation of a particular functional specification of a circuit to include, for a given embodiment, a large number of devices (e.g., millions of transistors). Accordingly, the sheer volume of this information makes it impractical to provide a full recitation of the low-level structure used to implement a single embodiment, let alone the vast array of equivalent possible implementations. For this reason, the present disclosure describes structure of circuits using the functional shorthand commonly employed in the industry.

The Abstract is provided to comply with 37 C.F.R. § 1.72(b), to allow the reader to quickly ascertain the nature of the technical disclosure. The Abstract is submitted with the understanding that it will not be used to interpret or limit the scope or meaning of the claims.

Although the embodiments above have been described in considerable detail, numerous variations and modifications will become apparent to those skilled in the art once the above disclosure is fully appreciated. It is intended that the following claims be interpreted to embrace all such variations and modifications. TIA and amplifier for the capacitance compensation network.

### Numbered Clauses

By way of non-limiting example, some aspects of the disclosure are set out in the following numbered clauses.
1. Numbered Clause 1. A circuit comprising:
   a first amplifier configured to operate as a transimpedance amplifier by:
      receiving an input current on an inverting input terminal; and
      generating an output voltage based on the input current;
   a second amplifier, wherein a non-inverting input terminal of the amplifier is connected to the inverting input terminal of the first amplifier;
   a first capacitor connected in between an output terminal of the second amplifier and the inverting input terminal of the first amplifier, wherein a capacitance of the first capacitor is within a threshold percentage of a total input capacitance associated with the inverting input terminal of the first amplifier; and
   a pair of resistors connected in series between the output terminal of the first amplifier and ground, wherein a midpoint of the pair of resistors is connected to an inverting input terminal of the second amplifier.
2. The circuit of claim 1, wherein the pair of resistors comprises a first resistor and a second resistor, and wherein a first resistance of the first resistor matches a second resistance of the second resistor.
3. The circuit of claim 1 or 2, further comprising a photodetector configured to generate the input current based on a received illumination.
4. The circuit of claim 3, wherein a voltage at an output of the second amplifier is double a voltage across the photodetector.
5. The circuit of claim 4, further comprising a capacitive voltage divider formed by the first capacitor and a photodetector capacitor in series.
6. The circuit of any of claims 3 to 5, wherein the second amplifier has a gain of two.
7. The circuit of claim 6, wherein the second amplifier having a gain of two causes a first voltage across the first capacitor to be equal to a second voltage across a photodetector capacitor.
8. A system comprising:
   a photodetector; and
   a circuit comprising:
      a first amplifier configured to operate as a transimpedance amplifier by receiving an input current on an inverting input terminal and generating an output voltage based on the input current;
      a second amplifier, wherein a non-inverting input terminal of the amplifier is connected to the inverting input terminal of the first amplifier;
      a first capacitor connected in between an output terminal of the second amplifier and the inverting input terminal of the first amplifier, wherein a capacitance of the first capacitor is within a threshold percentage of a total input capacitance associated with the inverting input terminal of the first amplifier; and
      a pair of resistors connected in series between the output terminal of the first amplifier and ground, wherein a midpoint of the pair of resistors is connected to an inverting input terminal of the second amplifier.
9. The system of claim 8, wherein the pair of resistors comprises a first resistor and a second resistor, and wherein a first resistance of the first resistor matches a second resistance of the second resistor.
10. The system of claim 8 or 9, wherein the photodetector is configured to generate the input current.
11. The system of any of claims 8 to 10, wherein a voltage at an output of the second amplifier is double a voltage across the photodetector.
12. The system of any of claims 8 to **11,** wherein the first capacitor in series with a photodetector capacitor act as a capacitive voltage divider.
13. The system of any of claims 8 to 12, wherein the second amplifier has a gain of two.
14. The system of claim 13, wherein the second amplifier having a gain of two causes a first voltage across the first capacitor to be equal to a second voltage across a photodetector capacitor.
15. A method comprising:
   receiving an input current on an inverting input terminal of a first amplifier configured to operate as a transimpedance amplifier;
   receiving the input current at a non-inverting input terminal of a second amplifier having a gain of two;
   conveying an output of the second amplifier through a compensation capacitor in series with the input capacitance of the first amplifier, wherein the combination of the compensation capacitor and the input capacitance of the first amplifier act as a capacitive voltage divider that divides the output of the second amplifier down to a same voltage as an output of a photodetector; and
   generating, by the first amplifier, an output voltage based on the input current, with the first amplifier having improved bandwidth characteristics due to the compensation capacitor cancelling parasitic input capacitance at an input of the first amplifier.
16. The method of claim 15, wherein the gain of two for the second amplifier is created by a pair of resistors in series.
17. The method of claim 15 or 16, further comprising generating, by the photodetector, the input current.
18. The method of any of claims 15 to 17, wherein a voltage across the compensation capacitor is equal to a voltage across a photodetector capacitor.
19. The method of claim 18, wherein the compensation capacitor and the photodetector capacitor form a capacitive voltage divider.
20. The method of any of claims 15 to 19, wherein a voltage at an output of the second amplifier is double a voltage across the photodetector.

## Claims

1. A circuit comprising:
a first amplifier configured to operate as a transimpedance amplifier by:
receiving an input current on an inverting input terminal; and
generating an output voltage based on the input current;
a second amplifier, wherein a non-inverting input terminal of the amplifier is connected to the inverting input terminal of the first amplifier;
a first capacitor connected in between an output terminal of the second amplifier and the inverting input terminal of the first amplifier, wherein a capacitance of the first capacitor is within a threshold percentage of a total input capacitance associated with the inverting input terminal of the first amplifier; and
a pair of resistors connected in series between the output terminal of the first amplifier and ground, wherein a midpoint of the pair of resistors is connected to an inverting input terminal of the second amplifier.

2. The circuit of claim 1, wherein the pair of resistors comprises a first resistor and a second resistor, and wherein a first resistance of the first resistor matches a second resistance of the second resistor.

3. The circuit of claim 1 or 2, further comprising a photodetector configured to generate the input current based on a received illumination.

4. The circuit of claim 3, wherein a voltage at an output of the second amplifier is double a voltage across the photodetector.

5. The circuit of claim 4, further comprising a capacitive voltage divider formed by the first capacitor and a photodetector capacitor in series.

6. The circuit of any of claims 3 to 5, wherein the second amplifier has a gain of two.

7. The circuit of claim 6, wherein the second amplifier having a gain of two causes a first voltage across the first capacitor to be equal to a second voltage across a photodetector capacitor.

8. A system comprising:
a photodetector; and
a circuit according to any of claims 1 to 7.

9. A method comprising:
receiving an input current on an inverting input terminal of a first amplifier configured to operate as a transimpedance amplifier;
receiving the input current at a non-inverting input terminal of a second amplifier having a gain of two;
conveying an output of the second amplifier through a compensation capacitor in series with the input capacitance of the first amplifier, wherein the combination of the compensation capacitor and the input capacitance of the first amplifier act as a capacitive voltage divider that divides the output of the second amplifier down to a same voltage as an output of a photodetector; and
generating, by the first amplifier, an output voltage based on the input current, with the first amplifier having improved bandwidth characteristics due to the compensation capacitor cancelling parasitic input capacitance at an input of the first amplifier.

10. The method of claim 9, wherein the gain of two for the second amplifier is created by a pair of resistors in series.

11. The method of claim 9 or 10, further comprising generating, by the photodetector, the input current.

12. The method of any of claims 9 to 11, wherein a voltage across the compensation capacitor is equal to a voltage across a photodetector capacitor.

13. The method of claim 12, wherein the compensation capacitor and the photodetector capacitor form a capacitive voltage divider.

14. The method of any of claims 9 to 13, wherein a voltage at an output of the second amplifier is double a voltage across the photodetector.
